Europäisches Patentamt

European Patent Office

Office européen des brevets

(11) Publication number: **0 106 029**
**B1**

## (12) EUROPEAN PATENT SPECIFICATION

(45) Date of publication of patent specification: **02.01.86**

(51) Int. Cl.⁴: **G 01 R 19/00, G 01 R 13/34**

(21) Application number: **83106969.5**

(22) Date of filing: **15.07.83**

(54) **Method and apparatus for measuring the amplitude of a noise-affected periodic signal without phase reference.**

(30) Priority: **19.07.82 IT 6791982**

(43) Date of publication of application:
**25.04.84 Bulletin 84/17**

(45) Publication of the grant of the patent:
**02.01.86 Bulletin 86/01**

(84) Designated Contracting States:
**AT BE CH DE FR GB LI NL SE**

(56) References cited:

**RADIO FERNSEHEN ELEKTRONIK, vol. 28, no. 7, Juli 1979, pages 415-418, Berlin, DD., W. BECKER: "Signal-Mittelwertbildung nach dem Boxcarverfahren"**

**WESCON CONFERENCE RECORD, vol. 25, September 1981, pages 1-7, El Segundo, CA, USA, R. TALAMBIRAS: "Sampling network analyzer for periodic functions"**

(73) Proprietor: **CSELT Centro Studi e Laboratori Telecomunicazioni S.p.A.**
**Via Guglielmo Reiss Romoli, 274**
**I-10148 Turin (IT)**

(72) Inventor: **De Bortoli, Marco**
**Via Campiglia, 37**
**Torino (IT)**
Inventor: **Tofanelli, Adler**
**Via Magenta, 20**
**Collegno (TO) (IT)**
Inventor: **Varetto, Luigi**
**Via Lunga, 10**
**San Mauro Torinese (TO) (IT)**

(74) Representative: **Riederer Freiherr von Paar zu Schönau, Anton et al**
**Freyung 615 Postfach 2664**
**D-8300 Landshut (DE)**

Courier Press, Leamington Spa, England.

# Description

The present invention relates to the measurement of electrical magnitudes and more particularly it concerns a method of and an apparatus for measuring the amplitude of a heavily noise-affected periodic signal without phase reference.

This occurs, for instance, when an attenuation measurement is to be effected in the field on an optical carrier for telecommunications systems. The measurement set generally consists of a generator of optical radiations, modulated by a sinusoidal signal, placed at a connection end, and of a photodetector followed by an amplifier, at the other end. The amplifier is to present a high gain, so as to compensate for the attenuation introduced by the connection, and a low noise figure. Amplifiers of this kind present a limited bandwidth (less than 1 kHz), hence also the frequency of the periodic modulation signal to be low.

The extraction of this signal from noise, after detection, is effected with band-pass filters, tuned at the nominal frequency of the modulation signal.

The use of analog filters with a high ($\sim10^3$) quality factor causes serious problems. In fact, with temperature variation or component ageing, their nominal frequency varies. The us of quartz or mechanical filters is not convenient owing to the low signal frequency. Finally, the possibility of variations in the nominal frequency of the transmitted signal requires at the reception the use of a circuit able to follow these variations.

A further problem is due to the unavailability of phase and frequency reference at both connection ends, what excludes the use of lock-in structures for the measurement of periodic signals heavily affected by noise.

Another solution is based on the digital processing of the information, namely on digital filtering. In fact digital filter stability depends solely on the stability of the clock signal, which is generally obtained from a high-stability crystal oscillator.

Solutions using conventional filters with recursive or transversal structures are not quite suited to a measurement instrument. In fact, owing to the high number of operations required, truncation and rounding errors cannot be avoided, nor can long execution times.

The disadvantages above are overcome by the method and the apparatus provided by the present invention, which allow for the measurement of periodic signals having the maximum value and the zero crossing mutually phase-shifted by $\pi/2$, such as sinusoidal signals, in presence of 0 to −10 dB signal-to-noise ratios, with measurement times of some seconds, and with a wide dynamic range of the input signal. These performances are obtained with the execution of just additions and multiplications by powers of two, practically effected by simple shifting operations.

The present invention provides a method for measuring the amplitude of a periodic signal, whose maximum value and zero crossing are mutually phase-shifted by π2 within the period characterized in that:

— said periodic signal is sampled twice per period, in correspondence with the maximum value and zero crossing by a controllable phase pulse sequence;
— samples are converted into digital form;
— digital samples relating to the maximum value undergo a digital filtering operation;
— filtered samples undergo an accumulation every N samples and the result is divided by N;
— the absolute value of the amplitude is extracted from the quotient;
— digital samples relating to zero crossing undergo an accumulation every N samples;
— the signs of the results of the above-mentioned accumulations are compared with one another, thus obtaining a binary signal which assumes one of the two logic states depending on whether the signs are equal or not;
— the phase of said pulse sequence is advanced or delayed, with respect to the periodic signal phase, by a suitable predetermined quantity in function of the logic level of said binary signal every N samples.

These and other characteristics of the present invention will be made clearer by the following description of a preferred embodiment thereof given by way of example, and by the annexed drawing · showing the block diagram of the apparatus which implements the method.

The algorithm, the apparatus operation is based on, requires two samples per period T of the received signal, phase shifted by T/4 (π/2). The samples $C_K$ and $C'_K$, obtained at the two instants $t_k$ and $t_k+T/4$ in correspondence with the maximum value and the zero crossing, assume the forms:

$$C_k = A \sin[2\pi(f_0-f_s)t_k+\varphi+\Delta_k]+N_k$$

$$C'_k = A \sin[2\pi(f_0-f_s)t_k+\varphi+\Delta_k+\pi/2]+N'_k$$

where $N_k$ and $N'_k$ are the respective noise values, A and $f_0$ are the amplitude and the frequency of the signal to be measured, $\varphi$ is the initial sampling phase and $\Delta_k$ the correction of the sampling phase updated according to the relationship:

$$\Delta_k = \Delta_{k-1} + \Delta \cdot \text{sign}(Y_{k-1} \cdot Y'_{k-1}) \cdot \text{Mod}(k+N)$$

where $\Delta$ is the correction coefficient controlling the phase variation effected at each correction, $Y_{k-1}$ and $Y'_{k-1}$ are the samples obtained from $K_k$ and $C'_k$ after digital processing and Mod (k+N) is a function the value of which is 1 when k is a multiple of N and 0 in the other cases.

After the analog-to-digital conversion samples $C_k$ and $C'_k$ are digitally processed in order to reduce the noise effect by 50 to 60 dB, passing then to S/N ratios of 40 to 50 dB with an input S/N ratio better than −10 dB. To this purpose filtering operations are carried out by a filter having a band equal to f/1000. The structure used is a 1st order recursive filter, whose functional relationship is:

$$Z_k = C_k(1-\alpha) + Z_{k-1}\alpha$$

where $Z_k$ is the sample $C_k$ after filtering $Z_{k-1}$ is the sample delayed by a period, $\alpha$ is a multiplicative coefficient which determines the filter bandwidth.

The apparatus structure provides two branches in which $C_k$ and $C'_k$ are separately processed. In particular, $C_k$ undergoes first the already-described filtering and then it is averaged on N samples, thus obtaining:

$$Y = \frac{1}{N} \cdot (\Sigma_k^N\; Z_k)$$

while $C'_k$ only undergoes an accumulation, thus obtaining:

$$Y' = (\Sigma_k^N\; C'_k)$$

$\Delta_k$ can be obtained by these values.

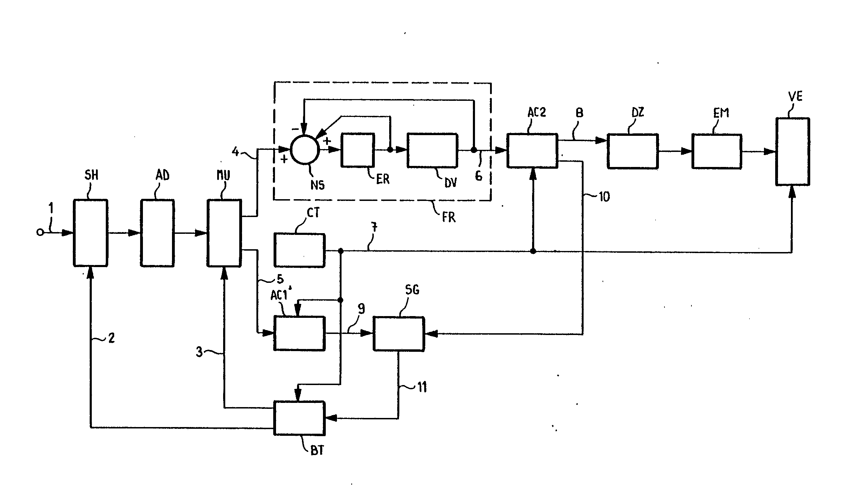

The block-diagram of the apparatus is shown in the Figure.

The periodic electrical signal as obtained by instance by detection of a modulated optical radiation, is present on wire 1, connected to the input of a sample-and-hold circuit SH. The sampling is controlled by a clock signal, delivered on wire 2 by a time-base BT and consisting of a sequence of pairs of pulses having a repetition frequency $f_0$, equal to the nominal frequency of the input signal and with a phase-shift equal to T/4 within the period. Hence the samples are converted into 12-bit words by an analog-to-digital converter AD and sent to a multiplexer MU, which is controlled by time base BT. BT sends via wire 3 a signal which renders sample $C_k$ available at the output connected to wire 4 and $C'_k$ available at the output connected to wire 5, by alternately extracting input signals at instants phase-shifted by T/4.

Through wire 4, $C_k$ accesses a 1st-order recursive filter FR, the transfer function of which has already been described.

This filter consists of an adder NS, of a delay element ER and of a scale-of-$2^{10}$ circuit, denoted by DV. The output is extracted downstream DV on wire 6 so as to normalize to 1 the d.c. filter gain.

The next 64 samples are then added in an accumulator AC2, controlled by the signal present on wire 7. The signal is generated by a counter CT and consists of a pulse every 64 periods of the clock signal at the nominal signal frequency. It causes the output of the result of the addition effected by AC2 over wire 8 and the resetting of the content of AC2 itself.

To bring again the gain of block AC2 to 1, the signal on wire 8 is divided by scale-of 64 circuit DZ.

DZ is then followed by a block EM which extracts the absolute value of the signal under test and sends it to a display device VE, where it is possible to have its visual or graphical representation, updated every 64 periods.

By wire 5, sample $C'_k$ accesses an accumulator AC1 where it is added 64 consecutive times. As for accumulator AC2 the operations of result transfer and reset are controlled by the signal coming from counter CT on wire 7.

The signs of the results of the accumulations effected by AC1 and AC2, respectively present on wire 9 and 10, are compared with each other by comparator SG. SG supplies at the output on wire 11 a binary signal, the logic level of which depends on the equality or inequality of the input signs. This signal causes a phase delay or a phase advance of the signal generated by BT for the sampling. Hence, the phase correction takes place every 64 periods of the signal.

Let us see now the operation of the apparatus from when the signal to be measured is sent to the input, to the moment of the phase-locking and of the next amplitude measurement.

The signal received on wire 1 is initially sampled at a random phase and sent to two main branches, respectively connected to wires 4 and 5.

In the case the samples do not correspond to the maximum value and to the zero crossing of the periodic signal, comparator SG supplies BT with the information of the correction direction, which is effected at the transition of the signal on wire 7. In particular, if the two sampling operations, phase-shifted by π/2, take place in the same half-period, the correction is such that it delays the first of the successive samplings by a time interval equal to Δ. In the case the two samplings take place across the zero crossing, the correction is effected in a direction opposite to the preceding one.

After a certain time, determined by the choice of the number N of samples on which the mean has been calculated, by the choice of the correction coefficient Δ and by the input signal characteristics (signal-to-noise ratio, drift of the periodic signal frequency from its nominal value) locking conditions are attained. Such conditions are checked and if necessary, updated every N sampling operations.

The locking conditions are signalled to the user by the stability of the indication on display VE.

A good compromise between measurement rate, which is important in case of repeated measurements effected in the field, and their accuracy, is obtained by a suitable design of parameters Δ, N and α.

The relationship between the maximum lock time, $t_{max}$, and parameters Δ and N is the following:

$$t_{max} = \frac{N \cdot T}{4[\Delta \pm N(f_0 - f_s)]}$$

while $\alpha$, which determines the bandwidth of filter FR, can be chosen on the basis of the required accuracy. In the example above it is equal to $1 - 1/2^{10}$, where $2^{10}$ is the reduction factor introduced by DV and N is equal to 64.

The above description has been given only by way of example and not in a limiting sense. Variations and modifications could be made while remaining within the scope of the invention.

**Claims**

1. Method for measuring the amplitude of a periodic signal, whose maximum value and zero crossing are mutually phase-shifted by $\pi/2$ within the period, characterized in that:

— said periodic signal is sampled twice per period, in correspondence with the maximum value and zero-crossing by a controllable phase pulse sequence;
— samples are converted into digital form;
— digital samples ($C_k$) relating to the maximum value undergo a digital filtering operation;
— filtered samples ($Z_k$) undergo an accumulation every N samples and the result is divided by N;
— the absolute value of the amplitude is extracted from the quotient (Y);
— digital samples ($C'_k$) relating to zero crossing undergo an accumulation every N samples;
— the signs of the results of the above-mentioned accumulations are compared with one another, thus obtaining a binary signal which assumes one of the two logic states depending on whether the signs are equal or not;
— the phase of said pulse sequence is advanced or delayed, with respect to the periodic signal phase, by a suitable predetermined quantity ($\Delta$) in function of the logic level of said binary signal every N samples.

2. Apparatus capable of implementing the method of claim 1, characterized in that it comprises:

— a sample-and-hold circuit (SH), which receives at its input said periodic signal;
— an analog-to-digital converter (AD), able to convert the samples provided by said sample-and-hold circuit;
— a multiplexer (MU), capable of rendering available at one of its outputs (4) the digital sample of the maximum value and on the other (5) the digital sample of the zero-crossing, the samples above being delivered by said analog-to-digital converter;
— a digital filter (FR), operating on the samples of the maximum amplitude values;
— a first accumulator (AC2), able of adding N filtered samples;
— a scale-of-N circuit (DZ) operating on the sum signal delivered by said first accumulator;
— a circuit (EM), capable of extracting the absolute value from the signal supplied by the scale-of-N circuit;
— a display device (VE), capable of representing the periodic-signal amplitude value;
— a second accumulator (AC1), able to add N samples relating to zero crossings delivered by said multiplexer;
— a comparator (SG), able to detect the equality and inequality of the signs of the sum signals delivered by said first and second accumulators;
— a counter (CT), able to count N periods of the clock signal at the periodic-signal frequency and to control by the signal thus obtained the first and second accumulators, the display device and a time-base circuit (BT);
— a time-base circuit (BT), able to generate said pulse sequence for the control of the sample-and-hold circuit, and a signal for the control of the multiplexer by reducing or incrementing by said predetermined quantity ($\Delta$) the phase of the signals generated in correspondence with the transitions of the signal delivered by the counter.

3. Device as in claim 2, characterized in that said digital filter (FR) is a first-order recursive filter.

**Patentansprüche**

1. Verfahren zum Messen der Amplitude eines periodischen Signals, dessen Maximalwerte und Nulldurchgänge gegeneinander innerhalb der Periode um $\pi/2$ phasenverschoben sind, dadurch gekennzeichnet, daß man

— das periodische Signal zweimal je Periode, nämlich in Übereinstimmung mit dem Maximalwert und dem Nulldurchgang, durch eine Impulsfolge mit steuerbarer Phase abtastet;
— die Abtastwerte in digitale Form umsetzt;
— die auf den Maximalwert bezogenen digitalen Abtastwerte ($C_k$) einer digitalen Filterung unterzieht;
— die gefilterten Abtastwerte ($Z_k$) zu jeweils N Werten einer Akkumulierung unterwirft und das Ergebnis durch N teilt;
— aus dem Quotienten (Y) den Absolutwert der Amplitude extrahiert;
— die auf die Nulldurchgänge bezogenen digitalen Abtastwerte ($C'_k$) zu jeweils N Werten einer Akkumulierung unterwirft;
— die Vorzeichen der Ergebnisse dieser Akkumulierungen miteinander vergleicht und so ein binäres Signal erhält, das in Abhängigkeit davon, ob die Vorzeichen gleich oder verschieden sind, einen der beiden logischen Zustände aufweist;
— die Phase der Impulsfolge in Bezug zur Phase des periodischen Signals in Funktion vom logischen Pegel des binären Signals alle N Abtastungen um eine entsprechende gegebene Menge (Δ) vor- oder zurückverschiebt.

2. Vorrichtung zur Durchführung des Verfahrens nach Anspruch 1, gekennzeichnet, durch:

— eine Tast- und Halteschaltung (SH), die eingangsseitig das periodische Signal empfängt;
— einen Analog/Digital-Umsetzer (AD), der die von der Tast- und Halteschaltung gelieferten Abtastwerte umsetzt;
— einen Multiplexer (MU), der an einem (4) seiner Ausgänge den digitalen Abtastwert des Maximalwerts und am anderen (5) den digitalen Abtastwert des Nulldurchgangswets verfügbar macht, wobei diese Abtastwerte vom Analog/Digital-Umsetzer geliefert werden;
— ein digitales Filter (FR), das die Abtastwerte der maximalen Amplituden verarbeitet;
— einen ersten Akkumulator (AC2), der N gefilterte Abtastwerte aufaddiert;
— eine N-Teilerschaltung (DZ), die das vom ersten Akkumulator abgegebene Summensignal verarbeitet;
— eine Schaltung (EM), die den Absolutwert aus dem von der N-Teilerschaltung abgegebenen Signal extrahiert;
— eine den Amplitudenwert des periodischen Signals darstellende Anzeigevorrichtung (VE);
— einen zweiten Akkumulator (AC1), der N auf die Nulldurchgänge bezogene Abtastwerte, die vom Multiplexer kommen, auf addiert;
— einen Komparator (SG), der die Gleichheit oder Ungleichheit der Vorzeichen der vom ersten und vom zweiten Akkumulator gelieferten Summensignale feststellt;
— einen Zähler (CT), der N Perioden des Taktsignals bei der Frequenz des periodischen Signals zählt und mit dem so erhaltenen Signal den ersten und den zweiten Akkumulator, die Anzeigevorrichtung une eine Zeitsteuerschaltung (BT) steuert;
— die Zeitsteuerschaltung (BT), die die Impulsfolge für die Steuerung der Tast- und Halteschaltung und ein Signal für die Steuerung des Multiplexers erzeugt, indem sie die Phase der in Übereinstimmung mit den Übergängen des vom Zähler gelieferten Signals erzeugten Signale um die gegebene Menge (Δ) vor- oder zurückverschiebt.

3. Vorrichtung nach Anspruch 2, dadurch gekennzeichnet, daß das digitale Filter (FR) einen rekursives Filter erster Ordnung ist.

**Revendications**

1. Procédé pour la mesure de l'amplitude d'un signal périodique, ayant sa valeur maximale et son passage par zéro déphasés entre eux de π/2 par période, caractérisé en ce que:

— ledit signal périodique est échantillonné deux fois par période en correspondance avec la valeur maximale et le passage par zéro à l'aide d'une séquence d'impulsions avec phase contrôlable;
— les échantillons sont soumis à une opération de conversion en forme numérique;
— les échantillons numériques ($C_k$) correspondants à la valeur maximale sont soumis à une opération de filtrage numérique;
— les échantillons filtrés ($Z_k$) sont soumis à une opération d'accumulation tous les n échantillons et le résultat est divisé par N;
— du quatient (Y) l'on extrait la valeur absolue de l'amplitude;
— les échantillons numériques ($C_k'$) relatifs aux passages par zéro sont soumis à une opération d'accumulation tous les n échantillons;
— les signes des résultats desdites opérations d'accumulation sont comparés entre eux, en obtenant ainsi un signal binarire qui prend un des deux étants logiques en fonction de l'égalité ou de l'inégalité des signes;
— la phase de ladite séquence d'impulsions est anticipée ou retardée, par rapport à la phase du signal périodique, d'une quantité prédéterminée (Δ) en fonction du niveau logique dudit signal binaire tous les n échantillons.

2. Dispositif apte à réaliser le procédé suivant la revendication 1, caractérisé en ce qu'il comprend:

— un circuit d'échantillonnage et de maintien (SH) à l'entrée duquel l'on envoie ledit signal périodique;
— un convertisseur analogique-numérique (AD), apte à convertir les échantillons fournis par ledit circuit d'échantillonnage et de maintien;
— un multiplexeur (MU), apte à rendre disponible à une de ses sorties (4) l'échantillon numérique correspondant à la valeur maximale et à l'autre sortie (5) l'échantillon numérique relatif au passage par zéro, lesdits échantillons étant fournis par ledit convertisseur analogique-numérique;
— un filtre numérique (FR) opérant sur l'échantillon relatif à la valeur maximale de l'amplitude;
— un premier accumulateur (AC2), apte à additionner n échantillons filtrés;
— un diviseur (DZ) modulo-N, opérant sur la somme fournie par ledit premier accumulateur;
— un circuit (EM) apte à prélever le module du signal fourni par le diviseur;
— un élément d'affichage (VE), apte à représenter la valeur de l'amplitude du signal périodique;
— un deuxième accumulateur (AC1), apte à additionner N échantillons relatifs aux passages par zéro fournis par ledit multiplexeur;
— un comparateur (SG), apte à détecter l'égalité ou l'inégalité des signes des sommes fournies par lesdits premier et deuxième accumulateurs;
— un compteur (CT), apte à compter N périodes du signal d'horloge à la fréquence du signal périodique et à commander par le signal ainsi obtenu le premier et le deuxième accumulateurs, l'élément d'affichage et un circuit de base de temps (BT);

— un circuit de base temps (BT), apte à engendrer ladite séquence d'impulsions pour la commande du circuit d'échantillonnage et de maintien et un signal pour la commande du multiplexeur, en imposant un retard ou une avance de phase de ladite quantité prédéterminée (Δ) aux signaux engendrés en correspondance des changements d'état du signal fourni par le compteur.

3. Dispositif suivant la revendication 2, caractérisé en ce que ledit filtre numérique (FR) est un filtre recursif du premier ordre.